(19) Europäisches Patentamt
European Patent Office
Office européen des brevets

(11) **EP 1 898 425 A1**

(12) **DEMANDE DE BREVET EUROPEEN**

(43) Date de publication:
**12.03.2008 Bulletin 2008/11**

(51) Int Cl.:
**G11C 16/02** *(2006.01)*  **G11C 7/10** *(2006.01)*

(21) Numéro de dépôt: **07015336.6**

(22) Date de dépôt: **06.08.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **05.09.2006 FR 0607743**

(71) Demandeur: **STMICROELECTRONICS SA**
**92120 Montrouge (FR)**

(72) Inventeurs:
• **Rodat, Christophe**
**13720 La Bouilladise (FR)**
• **Giovinazzi, Thierry**
**83470 Saint Maximin (FR)**

(74) Mandataire: **Marchand, André et al**
**OMNIPAT,**
**24 Place des Martyrs de la Résistance**
**13100 Aix-en-Provence (FR)**

(54) **Mémoire à changement de phase comprenant un décodeur de colonne basse tension**

(57) L'invention concerne un circuit intégré comprenant une mémoire non-volatile comprenant des cellules mémoire (CEL), un circuit (CSEL2) de sélection de cellule mémoire comprenant des blocs de sélection (SB), un premier dispositif (PLT) fournissant une première tension (Vp) applicable à des cellules mémoire, un second dispositif (SAMP) fournissant une seconde tension (Vr) applicable à des cellules mémoire. Selon l'invention chaque bloc (SB) de sélection d'une cellule mémoire comprend un premier sous-bloc de sélection (PSB) pour relier la cellule mémoire au premier dispositif et un second sous-bloc de sélection (NSB) pour relier la cellule mémoire au second dispositif. Le premier sous-bloc (PSB) ne comprend que des transistors MOS d'un premier type de conductivité (TP1, TP2), et le second sous-bloc (NSB) ne comprend que des transistors MOS d'un second type de conductivité (TN1, TN2). Application notamment aux mémoires à changement de phase.

**Fig. 5**

EP 1 898 425 A1

**Description**

La présente invention concerne le domaine des mémoires non-volatiles programmables et effaçables électriquement et notamment les mémoires comprenant des cellules mémoire à changement de phase (PCM).

Les points mémoire à changement de phase sont composés d'un matériau pouvant changer d'état physique sous l'effet d'un signal électrique, et plus précisément sous l'effet d'une élévation de température provoquée par un courant électrique le traversant (effet Joule). Ce changement d'état est rémanent et s'accompagne d'un changement des propriétés électriques du point mémoire. Dans une première phase dite amorphe le matériau présente une résistivité électrique élevée, et dans une seconde phase dite cristalline le matériau présente une faible résistivité électrique.

Les progrès réalisés sur les compositions de matériaux à changement de phase, par exemple des alliages à base d'éléments chimiques de la colonne VI de la table de Mendeleïev, comme le tellure Te ou le sélénium Se, sont tels que le changement de phase peut être obtenu avec une tension de faible valeur, par exemple de l'ordre de 6V, et un courant de quelques centaines de microampères seulement, ce qui permet l'intégration de points mémoire à changement de phase dans les mémoires implantées sur microplaquette de semi-conducteur.

A titre d'exemple, la figure 1 représente l'architecture d'un plan mémoire MA du type décrit par EP 1 450 373. Le plan mémoire MA comprend des cellules mémoire CELi,j,k agencées de façon matricielle et reliées chacune à une ligne de mot WLi de rang i et à une ligne de bit BLjk de rang j (j allant de 0 à m) appartenant à une colonne COLk de rang k. Chaque cellule mémoire CELi,j,k comprend un transistor de sélection TS, par exemple un transistor NMOS, et un point mémoire P à changement de phase. L'anode du point mémoire P est reliée à une ligne de bit BLjk et sa cathode est reliée à la masse (ou à une ligne de masse commutable) par l'intermédiaire du transistor de sélection TS. La borne de grille du transistor TS est reliée à une ligne de mot WLi.

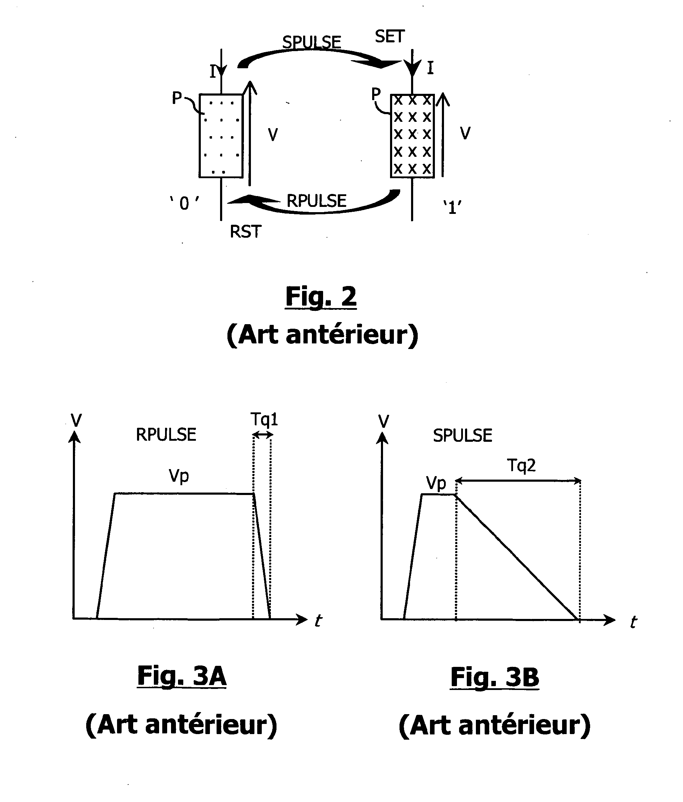

Comme illustré sur la figure 2, le point mémoire P présente deux états stables SET et RST (contraction de "RESET") correspondant aux deux types de résistivité précités. Dans l'état SET qui correspond par exemple à la mémorisation d'un "0" logique, le point mémoire présente une première résistance série, par exemple 5 à 10 KΩ, tandis que dans l'état RST correspondant à la mémorisation d'un "1" logique, le point mémoire présente une seconde résistance série, par exemple 100 à 200 KΩ.

Le passage de l'état SET à l'état RST (effacement) est assuré en appliquant au point mémoire une impulsion de tension RPULSE du type représenté en figure 3A, présentant un plateau de tension Vp d'une durée de l'ordre de 100 nanosecondes, par exemple, et un temps de descente Tq1 très rapide de l'ordre de quelques nanosecondes. La tension Vp et le courant correspondant (quelques centaines de microampères) provoquent par effet Joule un échauffement qui rend le matériau amorphe (état RST). Le passage de l'état RST à l'état SET (programmation) est assuré en appliquant au point mémoire une impulsion de tension SPULSE du type représenté en figure 3B, présentant un plateau de tension Vp d'une durée de l'ordre de 50 nanosecondes, par exemple, et un temps de descente Tq2 long de l'ordre de 300 nanosecondes par exemple. L'application d'une telle rampe de tension de durée Tq2 a pour effet de faire recristalliser le matériau, tandis que le temps de descente Tq1 de l'impulsion RPULSE doit au contraire être très court pour empêcher la recristallisation.

Une lecture du point mémoire P permet de déterminer si ce dernier présente la première ou la seconde résistance série. Une telle lecture doit être conduite sous une tension faible afin de ne pas modifier l'état du point mémoire en provoquant un effacement ou une programmation parasite. Pour fixer les idées, il est admis qu'une tension de lecture Vr de l'ordre de 0,5 V, inférieure à la tension de seuil d'un transistor MOS (généralement de l'ordre de 0,7 V), est suffisamment faible pour ne pas provoquer un changement d'état dans un point mémoire se trouvant dans l'état effacé ou programmé.

L'intégration de points mémoire à changement de phase dans une mémoire CMOS sur substrat de silicium est un objectif essentiel pour l'exploitation industrielle de cette technologie de mémoire, en raison du faible prix de revient des circuits intégrés CMOS. Ceux-ci comprennent des transistors d'un premier type de conductivité et des transistors d'un second type de conductivité, généralement appelés des transistors PMOS et NMOS.

De plus, le fait qu'il soit possible d'effacer ou de programmer les cellules mémoire avec une tension Vp de l'ordre de 6 V permet d'envisager une mémoire dépourvue de transistors haute tension, contrairement aux mémoires FLASH ou EEPROM utilisant des transistors à grille flottante haute tension pour contrôler une haute tension d'effacement ou programmation Vpp de l'ordre de 10 à 15V.

Toutefois, la tension Vp est proche de la tension maximale que peut supporter un transistor basse tension, ou "tension maximale technologique Vmax", voire égale à cette tension maximale.

Ainsi, il est souhaité de réaliser une mémoire de technologie CMOS permettant d'appliquer à des cellules mémoire à changement de phase, sans utiliser de transistor haute tension, une tension d'effacement ou programmation Vp qui est proche ou égale à la tension maximale technologique de la mémoire.

Il est également souhaité de pouvoir appliquer à des cellules mémoire une tension de lecture Vr de faible valeur, en utilisant des moyens d'application d'une structure simple et peu coûteuse à réaliser.

Or, les structures de mémoire CMOS selon l'art antérieur ne permettent pas d'atteindre ces objectifs. Cela sera compris en se référant à la figure 4 qui représente une architecture de mémoire du type décrit par la demande EP 1 450 373. La mémoire comprend un plan mémoire MA et des cellules mémoire à changement de phase du type décrit plus haut. La mémoire comprend également un circuit de sélection de colonne CSEL1 connecté aux lignes de bit BLjk du plan mémoire (les lignes de bit représentées étant des lignes BL0K à BLmk d'une même colonne COLk). Le circuit de sélection CSEL1 comprend des blocs de sélection de ligne de bit Bjk (B0k...Bmk) à raison d'un bloc par ligne de bit. Chaque bloc de sélection comprend en série deux transistors TP1, TP2 de type PMOS et un transistor TN1 de type NMOS. Les bornes de grille de ces transistors sont contrôlées par des signaux de sélection YMk, YNk, YOk fournis par un décodeur de colonne CDEC1. La borne de grille du transistor TP1 reçoit le signal YMk, la borne de grille du transistor TP2 reçoit le signal YNk et la borne de grille du transistor TN1 reçoit le signal YOk.

Pendant des phases d'effacement ou programmation de cellules mémoire, la tension Vp est fournie par des verrous d'effacement ou programmation PLTj (PLT0-PLTm) et est appliquée aux lignes de bit par l'intermédiaire des transistors de sélection TP1, TP2, TN1. A cet effet, les signaux YM et YN sont mis à 0 (masse du circuit) tandis que le signal YO doit être porté à une tension de grille au moins égale à Vp+Vth+Vb afin que la tension Vp soit transférée sans perte, Vth étant la tension de seuil des transistors MOS et Vb la tension d'effet de substrat ("body effect").

Ainsi, un premier inconvénient de cette mémoire classique est que le signal YO doit être survolté. Si la tension Vp est égale à la tension maximale technologique Vmax, la fourniture du signal YO égal à Vp+Vth+Vb (soit Vmax+Vth+Vb) n'est pas possible ou nécessite des transistors haute tension dans le décodeur de colonne CDEC1 ainsi qu'une pompe de charge (circuit survolteur) pour fournir la tension Vp+Vth+Vb.

Pendant des phases de lecture de cellules mémoire, des amplificateurs de lecture SAMPj (SAMP0-SAMPm) fournissent une tension Vbl qui est appliquée aux lignes de bit par l'intermédiaire des transistors de sélection TP1, TP2, TN1. Cette tension est limitée par le transistor TN1 en ajustant la tension de grille de ce transistor au voisinage de la valeur Vr+Vth+Vb, afin que les cellules mémoire ne reçoivent que la tension de lecture Vr. Or, un contrôle précis du niveau de tension du signal de sélection YO est incompatible avec la réalisation d'un décodeur de colonne de structure simple et peu coûteuse, délivrant des signaux binaires.

Une autre solution connue pour lire un point mémoire à changement de phase consiste à utiliser un amplificateur de lecture fournissant une tension de lecture Vbl égale à Vr, par exemple un amplificateur de lecture tel que décrit dans la demande PCT/FR2006/001686. Toutefois, dans ce cas, la tension de lecture Vr, par exemple 0,5 V, doit pouvoir être transférée sans atténuation par les transistors TP1, TP2, TN1. Cela impose de porter les signaux YM, YN qui contrôlent les bornes de grille des transistors TP1, TP2 à une valeur négative égale ou inférieure à -(Vth+Vp). Des pompes de charge à tension négative doivent ainsi être prévues, cela compliquant encore plus l'architecture du décodeur de colonne CDEC1. Doivent également recevoir une tension négative les bornes de grille de transistors d'isolement TI qui relient les verrous d'effacement ou programmation aux lignes de bit.

La présente invention vise ainsi une structure de mémoire qui permette d'appliquer à des cellules mémoire une tension d'effacement ou programmation Vp sans devoir utiliser des transistors haute tension ni devoir fournir des tensions de contrôle supérieures à la tension Vp.

La présente invention vise également une structure de mémoire qui permette d'appliquer aux cellules mémoire une tension de lecture de valeur inférieure à une tension de seuil de transistor MOS, sans devoir appliquer des tensions négatives à des bornes de grille de transistors.

A cet effet, la présente invention prévoit un circuit intégré comprenant une mémoire non-volatile comprenant des cellules mémoire, un circuit de sélection de cellule mémoire comprenant des blocs de sélection de cellule mémoire comprenant chacun des transistors de sélection de type MOS, un premier dispositif fournissant une première tension applicable à des cellules mémoire, un second dispositif fournissant une seconde tension applicable à des cellules mémoire, dans lequel chaque bloc de sélection d'une cellule mémoire comprend en parallèle un premier sous-bloc de sélection pour relier la cellule mémoire au premier dispositif et un second sous-bloc de sélection pour relier la cellule mémoire au second dispositif, le premier sous-bloc ne comprend que des transistors MOS d'un premier type de conductivité, et le second sous-bloc ne comprend que des transistors MOS d'un second type de conductivité.

Selon un mode de réalisation, le circuit intégré comprend un décodeur d'adresse de cellule mémoire fournissant aux bornes de grille dés transistors des premier et second sous-blocs des blocs de sélection, des signaux de sélection de cellule mémoire polarisés de telle sorte que, quand une cellule mémoire doit être sélectionnée, le premier sous-bloc du bloc de sélection de la cellule mémoire est dans l'état passant et le second sous-bloc du bloc de sélection est dans l'état bloqué ou vice-versa, selon que la cellule mémoire doit être reliée au premier ou au second dispositif.

Selon un mode de réalisation, le premier sous-bloc et le second sous-bloc de chaque bloc de sélection sont commandés par des signaux de sélection identiques.

Selon un mode de réalisation, le décodeur d'adresse comprend un étage de décodage d'adresse fournissant des premiers signaux logiques de sélection en fonction d'une adresse de cellule mémoire, et un étage d'adaptation recevant un signal de contrôle et fournissant des seconds signaux logiques de sélection fonction des premiers signaux de sélection, les seconds signaux de sélection étant appliqués aux premier et second sous-blocs des blocs de sélection en tant que signaux de sélection, l'étage d'adaptation étant agencé pour que les seconds signaux de sélection présentent une valeur logique inverse de celle des premiers signaux de sélection lorsque le signal de contrôle présente une première valeur et une valeur logique identique à celle des premiers signaux de sélection lorsque le signal de contrôle présente une seconde valeur.

Selon un mode de réalisation, chaque cellule mémoire est reliée au premier dispositif par un chemin comprenant les transistors du premier sous-bloc d'un bloc de sélection de la cellule mémoire et un ou plusieurs transistors additionnels en série avec les transistors du premier sous-bloc, et est reliée au second dispositif par un chemin comprenant les transistors du second sous-bloc du bloc de sélection de la cellule mémoire et un ou plusieurs transistors additionnels en série avec les transistors du second sous-bloc, le ou les transistors additionnels en série avec le premier sous-bloc est ou sont du même type de conductivité que les transistors du premier sous-bloc, et le ou les transistors additionnels en série avec le second sous-bloc du bloc de sélection est ou sont du même type de conductivité que les transistors du second sous-bloc.

Selon un mode de réalisation, le premier dispositif fournit une tension d'effacement ou programmation de cellule mémoire et les transistors du premier type sont des transistors PMOS.

Selon un mode de réalisation, le second dispositif fournit une tension de lecture de cellule mémoire et les transistors du second type sont des transistors NMOS.

Selon un mode de réalisation, le premier dispositif fournit une tension égale ou proche d'une tension maximale technologique que peut supporter un transistor MOS basse tension, et les transistors du premier type sont des transistors PMOS.

Selon un mode de réalisation, le second dispositif fournit une tension inférieure à la tension de seuil d'un transistor MOS, et les transistors du second type sont dés transistors NMOS.

Selon un mode de réalisation, le circuit intégré comprend un plan mémoire dans lequel les cellules mémoire sont reliées à des lignes de bit, le circuit de sélection de cellule mémoire est un circuit de sélection de ligne de bit comprenant pour chaque ligne de bit sélectionnable un bloc de sélection de ligne de bit comportant en parallèle un premier sous-bloc pour relier la ligne de bit au premier dispositif et un second sous-bloc pour relier la ligne de bit au second dispositif, le premier sous-bloc ne comprenant que des transistors d'un premier type de conductivité, et le second sous-bloc ne comprenant que des transistors d'un second type de conductivité.

Selon un mode de réalisation, le circuit de sélection de ligne de bit est éclaté en deux parties agencées de part et d'autre du plan mémoire, la première partie ne comprenant que les premiers sous-blocs des blocs de sélection et la seconde partie ne comprenant que les second sous-blocs des blocs de sélection, les premiers sous-blocs étant reliés à des premières extrémités de lignes de bit et les seconds sous-blocs étant reliés à des secondes extrémités de lignes de bit.

Selon un mode de réalisation, le premier et le second sous-blocs d'un bloc de sélection ne comprennent chacun qu'un seul transistor.

Selon un mode de réalisation, le premier et le second sous-blocs d'un bloc de sélection comprennent chacun au moins deux transistors en série.

Selon un mode de réalisation, le circuit intégré comprend des points mémoire à changement de phase.

L'invention concerne également un procédé pour appliquer à des cellules mémoire une première tension et une seconde tension, par l'intermédiaire d'un circuit de sélection de cellule mémoire comprenant des blocs de sélection de cellule mémoire comprenant chacun des transistors de sélection de type MOS, le procédé comprenant des étapes consistant à prévoir dans chaque bloc de sélection d'une cellule mémoire un premier sous-bloc de sélection et un second sous-bloc de sélection en parallèle, le premier sous-bloc ne comprenant que des transistors MOS d'un premier type de conductivité , et le second sous-bloc ne comprenant que des transistors MOS d'un second type de conductivité, appliquer la première tension aux cellules mémoire par l'intermédiaire des premiers sous-blocs des blocs de sélection, et appliquer la seconde tension aux cellules mémoire par l'intermédiaire des seconds sous-blocs des blocs de sélection.

Selon un mode de réalisation, le procédé comprend une étape consistant à appliquer aux bornes de grille des transistors des premier et second sous-blocs des blocs de sélection, des signaux de sélection de cellule mémoire polarisés de telle sorte que, quand une cellule mémoire doit être sélectionnée, le premier sous-bloc du bloc de sélection de la cellule mémoire est dans l'état passant et le second sous-bloc du bloc de sélection est dans l'état bloqué ou vice-versa, selon que la cellule mémoire doit être reliée au premier ou au second dispositif.

Selon un mode de réalisation, le procédé comprend une étape consistant à commander le premier sous-bloc et le second sous-bloc de chaque bloc de sélection au moyen des signaux de sélection identiques.

Selon un mode de réalisation, le procédé comprend des étapes consistant à : fournir des premiers signaux logiques de sélection en fonction d'une adresse de cellule mémoire, fournir des seconds signaux logiques de sélection présentant une valeur logique inverse de celle des premiers signaux de sélection ou une valeur logique identique à celle des premiers signaux de sélection selon que les cellules mémoire doivent recevoir la première tension ou la seconde tension, et appliquer les seconds signaux de sélection aux premier et second sous-blocs des blocs de sélection en tant que signaux de sélection.

Selon un mode de réalisation, le procédé comprend des étapes consistant à : appliquer la première tension à des cellules mémoire par l'intermédiaire des transistors du premier sous-bloc d'un bloc de sélection de la cellule mémoire et d'un ou de plusieurs transistors additionnels en série avec les transistors du premier sous-bloc et du même type de conductivité que les transistors du premier sous-bloc, et appliquer la seconde tension à des cellules mémoire par l'intermédiaire des transistors du second sous-bloc du bloc de sélection de la cellule mémoire et d'un ou de plusieurs transistors additionnels en série avec les transistors du second sous-bloc et du même type de conductivité que les transistors du second sous-bloc.

Selon un mode de réalisation, la première tension est une tension d'effacement ou programmation de cellule mémoire et les transistors du premier type sont des transistors PMOS.

Selon un mode de réalisation, la seconde tension est une tension de lecture de cellule mémoire et les transistors du second type sont des transistors NMOS.

Selon un mode de réalisation, la première tension est égale ou proche d'une tension maximale technologique que peut supporter un transistor MOS basse tension, et les transistors du premier type sont des transistors PMOS.

Selon un mode de réalisation, la seconde tension est inférieure à la tension de seuil d'un transistor MOS, et les transistors du second type sont des transistors NMOS.

Selon un mode de réalisation, le procédé est appliqué à un plan mémoire dans lequel les cellules mémoire sont reliées à des lignes de bit, et comprend des étapes consistant à : agencer les premiers sous-blocs des blocs de sélection d'un côté du plan mémoire et les relier à des premières extrémités de lignes de bit, et agencer les seconds sous-blocs d'un autre côté du plan mémoire et les relier à des secondes extrémités de lignes de bit.

Selon un mode de réalisation, le procédé comprend une étape consistant à ne prévoir qu'un seul transistor dans le premier et le second sous-blocs d'un bloc de sélection.

Selon un mode de réalisation, le procédé comprend une étape consistant à prévoir au moins deux transistors en série dans le premier et le second sous-blocs d'un bloc de sélection.

Selon un mode de réalisation, la première tension est une tension d'effacement ou programmation de points mémoire à changement de phase et la seconde tension est une tension de lecture de points mémoire à changement de phase.

Des exemples de mise en oeuvre de l'invention seront exposés dans ce qui suit, à titre non-limitatif, en relation avec les figures jointes parmi lesquelles :

- la figure 1 précédemment décrite représente un plan mémoire comprenant des cellules mémoire à changement de phase,
- la figure 2 précédemment décrite représente un point mémoire à changement de phase dans l'état effacé et l'état programmé,
- les figures 3A et 3B précédemment décrites représentent des signaux de changement de phase appliqués à un point mémoire,

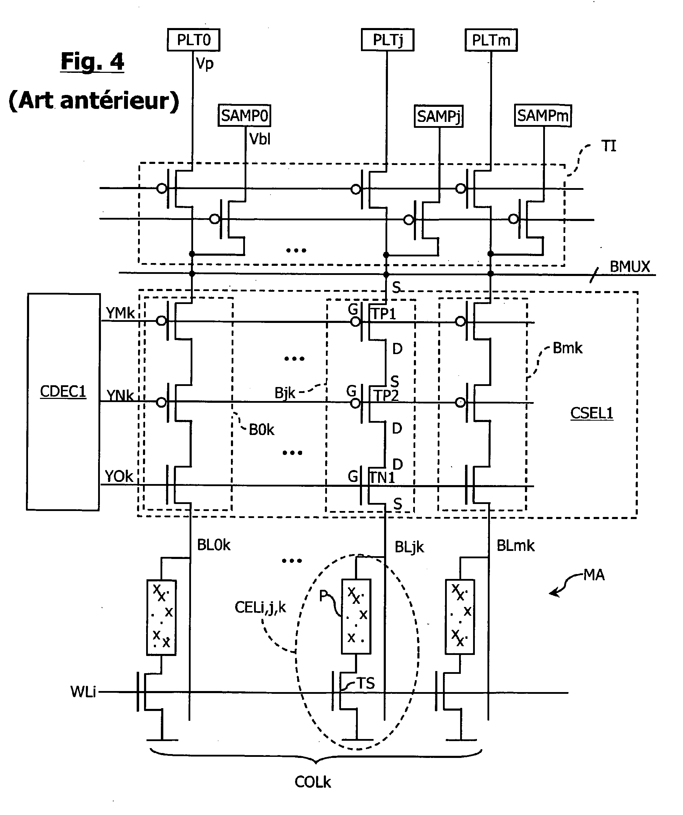

- la figure 4 précédemment décrite représente schématiquement une architecture de mémoire à changement de phase classique,
- la figure 5 représente schématiquement un exemple de réalisation d'une mémoire à changement de phase selon l'invention,
- la figure 6 représente de façon plus détaillée certains éléments de la mémoire de la figure 5,
- la figure 7 est un schéma équivalent de la mémoire de la figure 5, réduite à un point mémoire,
- la figure 8 représente un exemple de réalisation d'un décodeur de colonne présent dans la mémoire de la figure 5,
- la figure 9 représente un module d'adaptation présent dans le décodeur de la figure 8,
- la figure 10 est un schéma bloc qui illustre un second exemple de réalisation d'une mémoire selon l'invention, et
- la figure 11 représente une ligne de bit de la mémoire de la figure 10.

Description d'un exemple de réalisation d'une mémoire selon l'invention

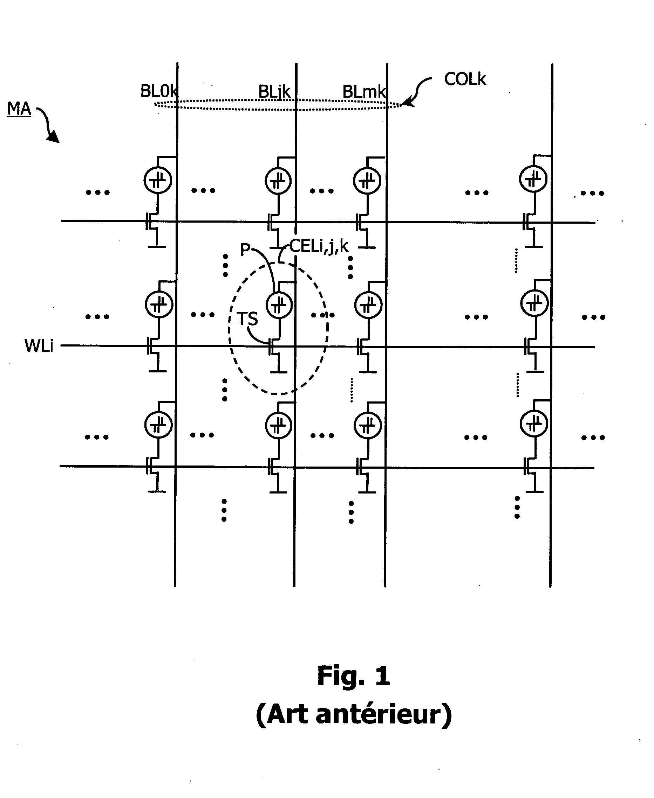

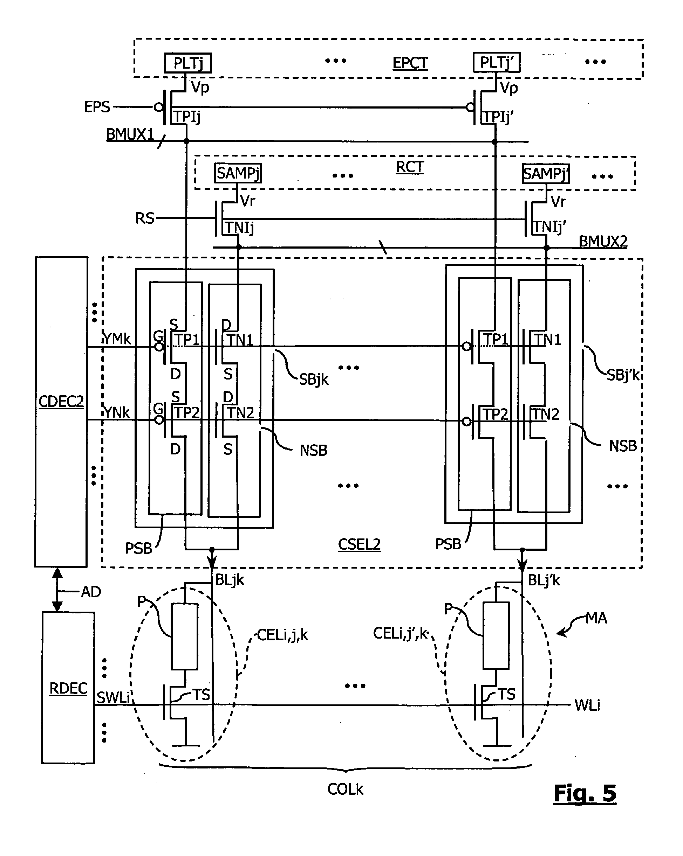

La figure 5 représente schématiquement une architecture de mémoire selon l'invention. La mémoire comprend un plan mémoire MA de même type que celui représenté en figure 1. Dans un souci de lisibilité de la figure, ne sont représentés que les éléments suivants du plan mémoire :

- une ligne de mot WL de rang i (Wli),
- deux lignes de bit BL de rang j et j' (BLjk, BLj'k) appartenant à une colonne COL de rang k (COLk), et
- deux cellules mémoire CEL (CELi,j,k, CELi,j',k) reliées respectivement à la ligne de bit BLjk et à la ligne de bit BLj'k, et reliées à la même ligne de mot WLi. Chaque cellule mémoire comprend un transistor de sélection TS et un point mémoire P à changement de phase.

Sont également représentés des éléments de rang i, j, j', k reliés à la ligne de mot Wli ou aux lignes de bit BLjk, BLj'k.

La mémoire comprend également un décodeur de ligne RDEC, un décodeur de colonne CDEC2, un circuit CSEL2 de sélection de colonne, un circuit de lecture RCT et un circuit d'effacement ou programmation EPCT. Le décodeur RDEC et le décodeur CDEC2 reçoivent respectivement les bits de poids fort et de poids faible d'une adresse AD d'un mot mémoire à sélectionner (mots de 8 cellules mémoire ou plus selon le nombre de lignes de bit par colonne). Le décodeur RDEC fournit des signaux SWL (SWLi) de sélection de ligne de mot WL. Le décodeur CDEC2 fournit des signaux YM, YN de sélection de colonne à raison de deux signaux de sélection (YMk, YNk) par colonne de rang k (COLk).

Le circuit EPCT comprend des verrous d'effacement ou programmation PLT (PLTj, PLTj') fournissant la tension d'effacement ou programmation Vp (créneaux RPULSE et SPULSE, fig. 3A, 3B). Le circuit RCT comprend des amplificateurs de lecture SAMP (SAMPj, SAMPj') fournissant une tension de lecture Vr de faible valeur, ici inférieure à la tension de seuil d'un transistor MOS, par exemple 0,5 V comme indiqué plus haut.

Chaque verrou PLT (PLTj, PLTj') est relié à des lignes de bit de même rang par l'intermédiaire d'un transistor d'isolement TPI de type PMOS (TPIj, TPIj'), d'un bus de multiplexage BMUX1, et du circuit de sélection de colonne CSEL2. Chaque amplificateur de lecture SAMP (SAMPj, SAMPj') est relié à des lignes de bit de même rang par l'intermédiaire d'un transistor d'isolement TNI (TNIj, TNIj') de type NMOS, d'un bus de multiplexage BMUX2 et du circuit de sélection de colonne CSEL2 (il sera noté que des lignes de bit de même rang appartiennent nécessairement à des colonnes de rangs différents, la figure 5 ne représentant que des lignes de bit d'une même colonne).

Le circuit de sélection CSEL2 comprend un bloc de sélection SB (SBjk, SBj'k) pour chaque ligne de bit BL (BLjk, BLj'k). Les blocs de sélection de ligne de bit appartenant à une même colonne COLk (par exemple les blocs SBjk, SBj'k représentés) reçoivent les mêmes signaux de sélection YM, YN (par exemple les signaux représentés YMk, YNk).

Structure des blocs de sélection

Selon l'invention, chaque bloc de sélection SB comprend deux sous-blocs de sélection PSB et NSB. Le sous-bloc PSB ne comprend que des transistors d'un premier type de conductivité agencés en série, ici des transistors PMOS. Le sous-bloc NSB ne comprend que des transistors d'un second type de conductivité agencés en série, ici des transistors NMOS.

Plus particulièrement, chaque sous-bloc NSB comprend ici deux transistors NMOS TN1, TN2 en série et chaque sous-bloc PSB comprend deux transistors PMOS TP1, TP2 en série. Les sous-blocs NSB, PSB d'un même bloc de sélection sont agencés en parallèle, le sous-bloc NSB reliant la ligne de bit concernée BL au verrou d'effacement ou programmation PLT correspondant, et le sous-bloc NSB reliant la ligne de bit concernée à l'amplificateur de lecture SAMP correspondant.

De plus, les sous-blocs NSB, PSB d'un même bloc de sélection de ligne de bit sont commandés ici par les mêmes signaux. Ainsi, les transistors TN1 et TP1 reçoivent le signal YM sur leur borne de grille et les transistors TN2 et TP2 reçoivent le signal YN sur leur borne de grille.

En résumé, chaque ligne de bit BL est reliée à un verrou de programmation PLT par un chemin électrique ne comprenant que des transistors PMOS, ici les deux transistors d'un sous-bloc de sélection PSB et un transistor d'isolement TPI. De même, chaque ligne de bit BL est reliée à un amplificateur de lecture SAMP par un chemin électrique ne comprenant que des transistors NMOS, ici deux transistors d'un sous-bloc de sélection NSB et un transistor d'isolement TNI.

Contrôle des blocs de sélection

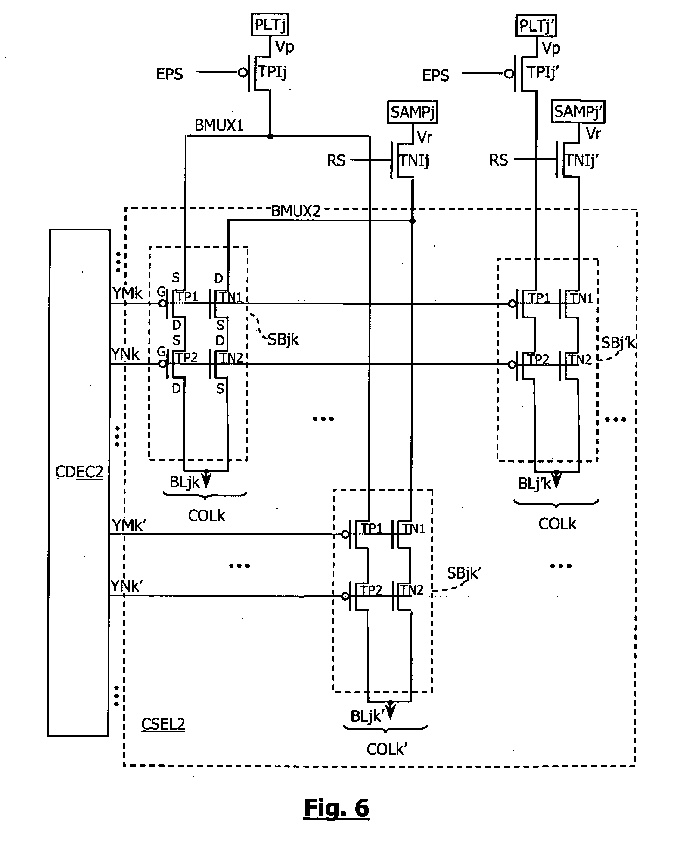

Un exemple de contrôle des blocs de sélection au moyen des signaux de sélection YM, YN sera maintenant décrit en relation avec la figure 6. La figure 6 représente, en sus des éléments déjà représentés sur la figure 5, une ligne de bit BLjk' de rang j appartenant à une colonne COLk' de rang k' et les éléments associés à cette ligne de bit, à savoir un bloc SBjk' de sélection de la ligne de bit et des signaux de sélection correspondant YMk', YNk'. La ligne de bit BLjk' est reliée au verrou PLTj par l'intermédiaire des transistors TP1, TP2 du bloc SBjk' et du transistor d'isolement TPIj. Elle est également reliée à l'amplificateur de lecture SAMPj via les transistors TN1, TN2 du bloc SBjk' et le transistor d'isolement TNIj.

On suppose ici que la colonne de rang k est sélectionnée, d'abord en effacement ou programmation, puis en lecture, et que les cellules mémoire concernées sont par exemple celles appartenant à une ligne de mot Wli représentée en figure 5 (les figures 5 et 6 se complétant mutuellement). Pour sélectionner ces cellules mémoire en effacement ou programmation, ou en lecture, le signal de sélection SWLi de la ligne de mot est mis à 1. Cette valeur logique de sélection est par exemple égale à une tension d'alimentation Vcc de la mémoire, par exemple 3 V, tant pendant des phases d'effacement ou de programmation que des phases de lecture. La tension Vcc met le transistor de sélection TS dans l'état passant.). Le point mémoire P est alors traversé par un courant d'effacement ou programmation égal à la tension Vp divisée par la résistance série du point mémoire, ou par un courant de lecture égal à la tension Vr divisée par la résistance série du point mémoire.

Phases d'effacement ou de programmation

Pendant les phases d'effacement ou de programmation, le "1" logique correspond à la tension d'effacement ou programmation Vp, qui est utilisée pour alimenter électriquement le décodeur CDEC2 ou au moins des étages de sortie de celui-ci (étages "drivers").

Les signaux YMk, YNk de sélection de la colonne de rang k sont mis à 0 (masse) tandis que les signaux YMk', YNk' de sélection de la colonne de rang k' sont mis à 1. Tous les transistors d'isolement TPI sont mis dans l'état passant au moyen d'un signal de contrôle de grille EPS égal à 0 tandis que tous les transistors d'isolement TNI sont mis dans l'état bloqué au moyen d'un signal de contrôle de grille RS égal à 0. Les verrous PLTj, PLTj' fournissent la tension Vp (en supposant que toutes les cellules mémoire appartenant à la colonne de rang k et à la ligne de mot WLi sont à effacer ou à programmer).

Les transistors TP1, TP2 des blocs SBjk, SBj'k reçoivent la tension Vp sur leur borne de source (S). Leur borne de grille (G) est mise à 0 par le décodeur de colonne CDEC2. Ces transistors PMOS sont ainsi dans l'état passant et transfèrent la tension Vp sur leur borne de drain (D) sans perte de tension à leurs bornes puisque leur tension source-grille est supérieure à leur tension de seuil Vth. Simultanément, les transistors TN1, TN2 des blocs SBjk, SBj'k sont dans l'état bloqué puisque leur borne de grille (G) est également maintenue à 0.

Ainsi, pendant les phases d'effacement ou de programmation, il n'est pas nécessaire que le décodeur CDEC2 fournisse des signaux de sélection supérieurs à la tension Vp. La fourniture de signaux YMk, YNk de valeur nulle (et de façon plus générale d'une tension inférieure à Vp-Vth) est suffisante pour transférer la tension Vp aux cellules mémoire concernées.

Au même instant, le bloc SBjk' reçoit les signaux de sélection YMk', YNk' égaux à 1, de sorte que les transistors PMOS de ce bloc de sélection sont dans l'état bloqué. Les autres blocs de sélection de ligne de bit du circuit CSEL2 reçoivent également des signaux de sélection égaux à 1 qui maintiennent leurs transistors PMOS respectifs dans l'état bloqué. Ainsi, seules les lignes de bit de la colonne COLk sélectionnée reçoivent la tension d'effacement ou programmation Vp, notamment les lignes de bit BLjk, BLj'k représentées sur la figure.

Phases de lecture

Pendant les phases de lecture, le "1" logique fourni par le décodeur CDEC2 correspond à la tension Vcc, utilisée pour alimenter électriquement le décodeur CDEC2.

Les signaux YMk, YNk de sélection de la colonne de rang k sont mis à 1 tandis que les signaux YMk', YNk' de sélection de la colonne de rang k' sont mis à 0. Les transistors d'isolement TPIj sont mis dans l'état bloqué par le signal EPS (EPS=1) tandis que les transistors d'isolement TNIj sont mis dans l'état passant par le signal RS (RS=1). Les amplificateurs de lecture SAMPj, SAMPj' fournissent la tension Vr.

Les transistors TN1, TN2 des blocs SBjk, SBj'k reçoivent la tension Vr sur leur borne de drain (D) et leur borne de grille (G) est mise à 1 par le décodeur de colonne CDEC2. Ces transistors sont ainsi tous deux dans l'état passant et transfèrent la tension Vr sur leur borne de source (S) sans perte de tension à leurs bornes puisque leur tension grille-source est supérieure à leur tension de seuil Vth (la tension Vr étant très inférieure à la tension Vcc).

Ainsi, pendant les phases de lecture, il n'est pas nécessaire que le décodeur CDEC2 fournisse des signaux de sélection modulés au voisinage de la valeur Vr+Vth+Vb ou qu'il fournisse des signaux de contrôle de grille de valeur négative. La fourniture de signaux YMk, YNk de valeur logique 1 correspondant par exemple à la tension Vcc (et de façon plus générale des signaux logiques de tension supérieure à Vr+Vth+Vb) permet de transférer la tension Vr aux cellules mémoire concernées, sans perte de tension.

Au même instant, le bloc de sélection SBjk' reçoit des signaux de sélection YMk', YNk' égaux à 0, de sorte que les transistors NMOS de ce bloc sont dans l'état bloqué. Les autres blocs de sélection de ligne de bit reçoivent également des signaux de sélection égaux à 0 qui bloquent les transistors NMOS. Ainsi, seules les lignes de bit de la colonne COLk sélectionnée reçoivent la tension de lecture Vr, notamment les lignes de bit BLjk, BLj'k représentées sur la figure.

En résumé, la mémoire selon l'invention comprend deux chemins distincts pour relier les lignes de bit aux verrous (ou tout autre élément fournissant la tension d'effacement ou programmation Vp) et aux amplificateurs de lecture. Le chemin électrique conduisant aux verrous est exclusivement composé de transistors PMOS (y compris les transistors d'isolement TPI) et permet de transférer la tension Vp en appliquant aux bornes de grille de ces divers transistors une tension nulle ou à tout le moins inférieure à Vp-Vth-Vb. Le chemin électrique conduisant aux amplificateurs de lecture est exclusivement composé de transistors NMOS (y compris les transistors d'isolement TNI) et permet de transférer la tension Vr en appliquant aux bornes de grille de ces divers transistors une tension non modulée supérieure à Vr+Vth+Vb, la solution la plus simple étant, comme indiqué plus haut, d'utiliser le niveau logique 1 qui correspond généralement à la tension d'alimentation Vcc de la mémoire.

Comme les transistors PMOS des blocs de sélection de ligne de bit doivent transférer un courant élevé pendant les phases d'effacement ou de programmation, par exemple 700 microampères, ces transistors sont plus généreusement dimensionnés que les transistors NMOS qui ne doivent transférer qu'un faible courant de lecture, par exemple 10 microampères. Ainsi, les transistors PMOS présente un ratio largeur sur longueur de grille (W/L) plus élevé que les transistors NMOS.

Schéma équivalent

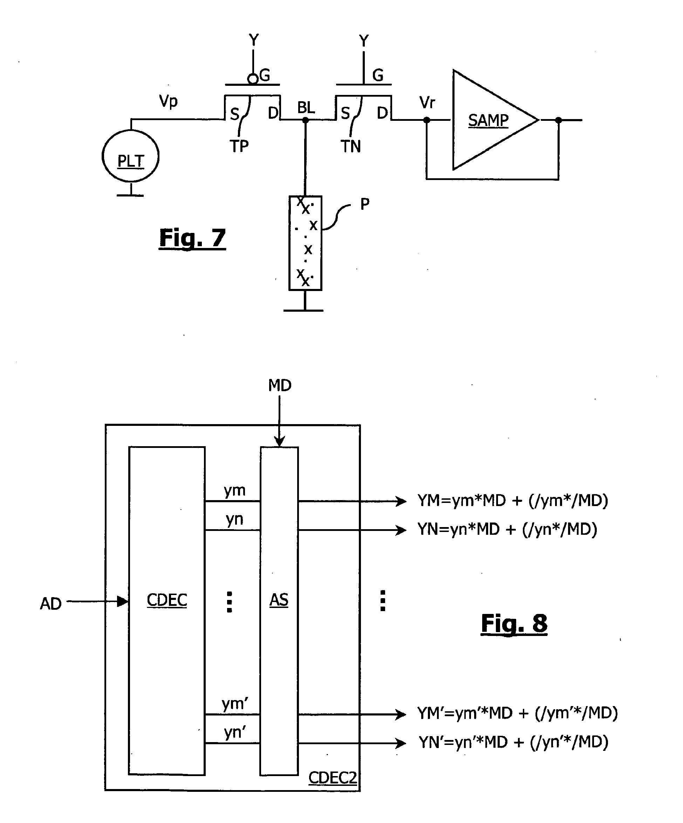

La figure 7 est un schéma équivalent de la mémoire précédemment décrite ramenée à une cellule mémoire. La cellule mémoire comprend un point mémoire P et un transistor de sélection qui est supposé dans l'état passant et n'est donc pas représenté. Le point mémoire P est relié à un noeud BL représentant une ligne de bit et le noeud BL est relié d'une part à un verrou d'effacement ou programmation PLT, par l'intermédiaire d'un transistor PMOS TP, et d'autre part à un amplificateur de lecture SAMP, par l'intermédiaire d'un transistor NMOS TN. Les transistors TP et TN sont pilotés par le même signal de sélection Y. Ainsi lorsque Y=0 le point mémoire est relié au verrou PLT et reçoit la tension Vp fournie par celui-ci et lorsque Y=1 le point mémoire est connecté à l'amplificateur SAMP et reçoit la tension de lecture Vr fournie par celui-ci.

A noter que la figure 7 peut également être le schéma "vrai" (non équivalent), ramené à une cellule mémoire, d'une mémoire selon l'invention dépourvue de transistors d'isolement et dans laquelle les blocs de sélection de ligne de bit ne comprennent chacun qu'un transistor PMOS en parallèle avec un transistor NMOS (ce qui nécessite que le décodeur CDEC2 fournisse un signal de sélection par colonne et un seul). De façon générale, le nombre de transistors PMOS ou NMOS que comprend chaque bloc de sélection de ligne de bit peut être variable en fonction du degré de décodage implémenté dans le décodeur de colonne CDEC2. Chaque bloc de sélection peut comprendre deux ou trois, voire quatre transistors en série de chaque type, mais un seul transistor de chaque type est également envisageable.

Aspects de l'invention relatifs au décodage d'adresse de colonne

L'utilisation des mêmes signaux de sélection YM, YN pour piloter à la fois les transistors NMOS et PMOS des blocs de sélection de ligne de bit est une caractéristique avantageuse de l'invention qui permet d'éviter de réaliser un décodeur dual qui comprendrait deux décodeurs de colonne en parallèle, l'un assurant le contrôle des transistors PMOS et l'autre le contrôle des transistors NMOS des blocs de sélection de ligne de bit.

Cela implique toutefois que, lorsque les transistors PMOS des blocs de sélection de ligne de bit appartenant à des colonnes non sélectionnées sont dans l'état bloqué, les transistors NMOS sont dans l'état passant, et vice-versa. Il convient dès lors de noter que cela n'est aucunement gênant puisque les transistors d'isolement TNI ou TPI empêchent les lignes de bit non sélectionnées d'être reliées aux amplificateurs de lecture (en mode effacement ou programmation) ou aux verrous (en mode lecture). Ces transistors d'isolement sont en outre optionnels et peuvent être supprimés si les amplificateurs de lecture et les verrous sont conçus pour que leur borne d'entrée ou de sortie soit à haute impédance en dehors des périodes de lecture, respectivement en dehors des périodes d'effacement ou programmation.

Par ailleurs, l'utilisation des mêmes signaux de sélection YM, YN pour piloter à la fois les transistors NMOS et PMOS des blocs de sélection implique que la valeur logique de ces signaux doit être inversée entre les phases d'effacement ou programmation et les phases de lecture.

La figure 8 représente un mode de réalisation simple du décodeur de colonne CDEC2 permettant de mettre en oeuvre cette caractéristique sans qu'il soit nécessaire de réaliser un décodeur dual. Le décodeur CDEC2 comprend un étage de décodage CDEC en soi classique et de même structure qu'un décodeur de colonne classique, fournissant des signaux logiques de sélection de colonne ym, yn, ym', yn', etc. Ces signaux sont appliqués à un étage d'adaptation AS qui fournit les signaux de sélection YM, YN, YM', YN' nécessaire à l'invention en fonction d'un signal MD et en fonction des signaux ym, yn, ym', yn'. Le signal MD est par exemple égal à 0 pendant les phases d'effacement ou programmation et à 1 pendant les phases de lecture. Les signaux de sélection fournis par l'étage AS sont par exemple égaux à :

$$YM = ym*MD + /ym*/MD$$

$$YN = yn*MD + /yn*/MD$$

$$YM' = ym'*MD + /ym'*/MD$$

$$YN' = yn'*MD + /yn'*/MD$$

Soit, quand MD = 0 :

$$YM = /ym$$

$$YN = /yn$$

$$YM' = /ym'$$

$$YN' = /yn'$$

Quand MD = 1 :

$$YM = ym$$

$$YN = yn$$

$$YM' = ym'$$

$$YN' = yn'$$

"*" étant la fonction ET, "+" la fonction OU et "/" la fonction inverseuse.

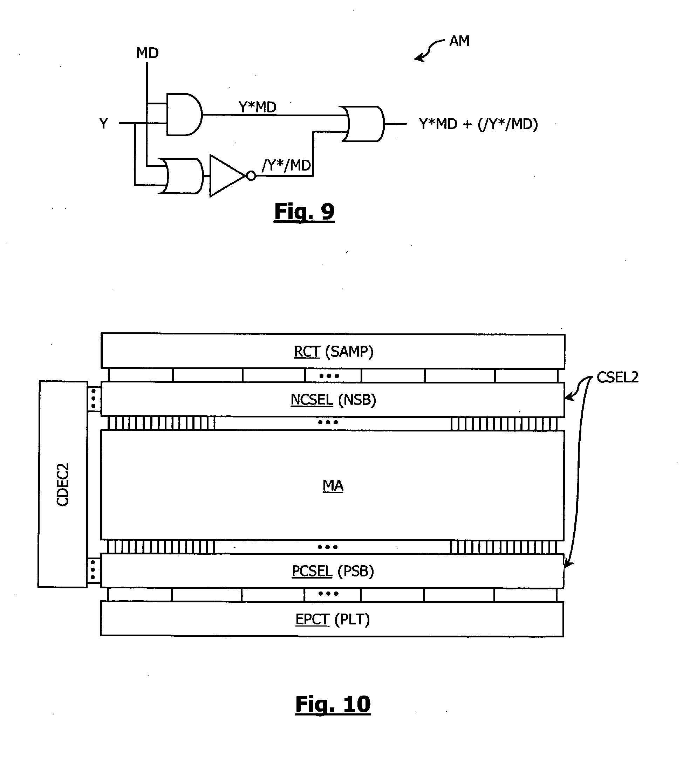

La figure 9 illustre un exemple de réalisation de modules d'adaptation AM formant l'étage d'adaptation AS et permettant d'inverser ou non chaque signal de sélection de colonne en fonction du signal MD conformément aux équations logiques ci-dessus. Les modules AM comprennent chacun deux portes OU, une porte inverseuse et une porte ET. Dans une variante de réalisation équivalente, ces modules sont des portes OU EXCLUSIF et réalisent ainsi la fonction :

$$YM = ym*/MD + /ym*MD$$

Aspects de l'invention relatifs à l'implantation des composants

Un autre aspect de l'invention concerne le "layout" de la mémoire, c'est-à-dire la manière dont les transistors PMOS et NMOS sont agencés à la surface d'une microplaquette de silicium. Selon cet aspect de l'invention, et comme illustré en figure 10, il est prévu

- d'agencer les circuits de lecture RCT (amplificateurs SAMP) et d'effacement ou programmation (verrous PLT) de part et d'autre du plan mémoire MA, le circuit RCT étant par exemple agencé "au-dessus" du plan mémoire (dans le plan du circuit intégré) et le circuit EPCT "au-dessous" du plan mémoire (toujours dans le plan du circuit intégré),
- de scinder le circuit de sélection de colonne CSEL2 en deux demi-circuits de sélection NCSEL et PCSEL ne comprenant respectivement que des transistors NMOS (sous-blocs NSB) et que des transistors PMOS (sous-blocs PSB),
- d'agencer le demi-circuit NCSEL au-dessus du plan mémoire, entre celui-ci et le circuit RCT, et
- d'agencer le demi-circuit PCSEL au-dessous du plan mémoire, entre celui-ci et le circuit EPCT.

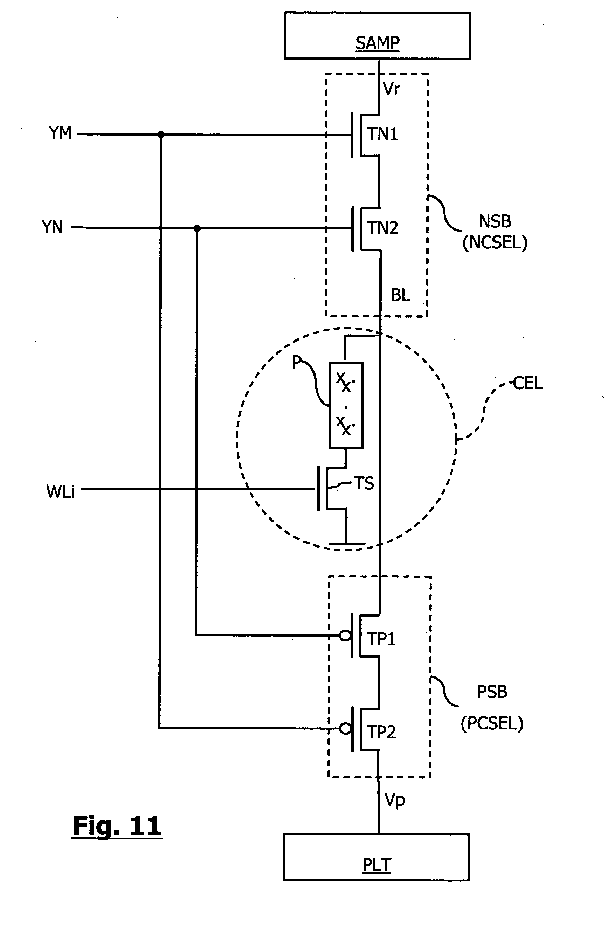

On obtient une structure de mémoire telle que représentée plus en détail en figure 11. Chaque ligne de bit BL (seule une ligne de bit étant représentée) présente une première extrémité reliée à un amplificateur SAMP par l'intermédiaire d'un sous-bloc de sélection NSB comprenant les transistors TN1, TN2, et une seconde extrémité reliée à un verrou PLT par l'intermédiaire d'un sous-bloc de sélection PSB comprenant les transistors TP1, TP2 (les transistors d'isolement et les bus de multiplexage n'étant également pas représentés). Cette structure de mémoire permet de réduire le pas ("pitch") entre les lignes de bit par rapport à une structure de mémoire telle que représentée en figure 5 ou 6, dans laquelle le pas entre les lignes de bit est imposé par la largeur des blocs SB, qui n'est pas négligeable en raison de l'agencement en parallèle des transistors PMOS et NMOS.

Variantes et applications de l'invention

Il apparaitra clairement à l'homme de l'art que la présente invention est susceptible de diverses autres variantes de réalisation, notamment en fonction de la structure de plan mémoire retenue.

La mémoire qui a été décrite dans ce qui précède à titre d'exemple de mise en oeuvre de l'invention est une mémoire effaçable et programmable par mot dans laquelle le nombre de bits par mot est défini par le nombre de lignes de bit que contient une colonne. En application des règles usuelles d'architecture des mémoires, l'invention s'applique également à une mémoire effaçable et programmable par bit dans laquelle la notion de colonne n'est pas mise en oeuvre (c'est-à-dire dans laquelle une colonne correspond à une ligne de bit et une seule). Dans un tel mode de réalisation, l'effacement ou la programmation des cellules mémoire s'effectue de façon individuelle et séquentielle (l'une après l'autre).

L'effacement et la programmation par bit peut être préféré à l'effacement ou la programmation par mot selon les contraintes technologiques intervenant dans la conception de la mémoire, notamment pour éviter de-devoir collecter un courant résultant important égal à la somme des courants d'effacement et de programmation traversant chacune des cellules mémoire concernées lors de l'écriture collective de toutes les cellules mémoire d'un mot. Ainsi, une mémoire effaçable et programmable par bit selon l'invention ne contient pas de colonnes à la différence d'une mémoire effaçable et programmable par mot. Une telle mémoire comporte un circuit de sélection permettant de sélectionner les lignes de bit individuellement au lieu d'un circuit de sélection de colonne, et le décodeur de colonne devient un décodeur de ligne de bit (décodeur d'adresse de ligne de bit).

Egalement, une mémoire selon l'invention peut ne comporter qu'une ligne de mot, les lignes de bit n'étant alors plus nécessaires. Une telle mémoire comporte ainsi un circuit de sélection permettant de sélectionner directement des cellules mémoire au lieu de sélectionner des lignes de bit.

Ainsi, la fonction essentielle du circuit de sélection de colonne selon l'invention est de relier au moins une cellule mémoire à un premier dispositif fournissant une première tension, ici une tension de lecture, et à un second dispositif fournissant une seconde tension, ici une tension d'effacement ou programmation.

Il apparaîtra ainsi à l'homme de l'art que la présente invention est susceptible de diverses applications et n'est pas limitée aux mémoires à changement de phase. Bien que l'invention ait été initialement conçue pour répondre au problème technique exposé au préambule, les avantages de l'invention peuvent être recherchés avec d'autres types de cellules mémoire, ces avantages étant essentiellement de permettre l'application d'une tension de forte valeur (Vp) aux cellules mémoire (via des lignes de bit ou non) au moyen d'un décodeur d'adresse fournissant des signaux de sélection ayant des niveau de tension logiques non survoltés et sans valeur négative, tout en permettant l'application aux cellules mémoire d'une tension de faible valeur au moyen du même décodeur d'adresse.

La présente invention concerne de façon générale tout type de circuit intégré comprenant une mémoire, de la mémoire simple vendue sous forme de circuit intégré aux circuits intégrés complexes comprenant une mémoire et divers éléments utilisant la mémoire, par exemple les microcontrôleurs.

## Revendications

**1.** Circuit intégré comprenant une mémoire non-volatile comprenant :

- des cellules mémoire (CEL),
- un circuit (CSEL2) de sélection de cellule mémoire comprenant des blocs (SB) de sélection de cellule mémoire comprenant chacun des transistors de sélection de type MOS (TN1, TN2, TP1, TP2),
- un premier dispositif (EPCT, PLT) fournissant une première tension (Vp) applicable à des cellules mémoire,
- un second dispositif (RCT, SAMP) fournissant une seconde tension (Vr) applicable à des cellules mémoire,

**caractérisé en ce que** :

- chaque bloc (SB) de sélection d'une cellule mémoire comprend en parallèle un premier sous-bloc de sélection (PSB) pour relier la cellule mémoire au premier dispositif (EPCT, PLT) et un second sous-bloc de sélection (NSB) pour relier la cellule mémoire au second dispositif (RCT, SAMP),
- le premier sous-bloc (PSB) ne comprend que des transistors MOS d'un premier type de conductivité (TP1, TP2), et
- le second sous-bloc (NSB) ne comprend que des transistors MOS d'un second type de conductivité (TN1, TN2) .

**2.** Circuit intégré selon la revendication 1, comprenant un décodeur d'adresse de cellule mémoire (CDEC2) fournissant aux bornes de grille des transistors des premier (PSB) et second (NSB) sous-blocs des blocs de sélection, des signaux de sélection de cellule mémoire (YM, YN) polarisés de telle sorte que, quand une cellule mémoire doit être sélectionnée, le premier sous-bloc (PSB) du bloc (SB) de sélection de la cellule mémoire est dans l'état passant et le second sous-bloc (NSB) du bloc de sélection est dans l'état bloqué ou vice-versa, selon que la cellule mémoire doit être reliée au premier (EPCT, PLT) ou au second (RCT, SAMP) dispositif.

**3.** Circuit intégré selon la revendication 2, dans lequel le premier sous-bloc (PSB) et le second sous-bloc (NSB) de chaque bloc de sélection sont commandés par des signaux de sélection identiques.

**4.** Circuit intégré selon la revendication 3, dans lequel le décodeur d'adresse comprend :

- un étage de décodage d'adresse (CDEC) fournissant des premiers signaux logiques de sélection (ym, yn) en fonction d'une adresse de cellule mémoire, et
- un étage d'adaptation (AS) recevant un signal de contrôle et fournissant des seconds signaux logiques de sélection (YM, YN) fonction des premiers signaux de sélection, les seconds signaux de sélection étant appliqués aux premier et second sous-blocs des blocs de sélection en tant que signaux de sélection, l'étage d'adaptation étant agencé pour que les seconds signaux de sélection (YM, YN) présentent une valeur logique inverse de celle des premiers signaux de sélection (ym, yn) lorsque le signal de contrôle présente une première valeur et une valeur logique identique à celle des premiers signaux de sélection (ym, yn) lorsque le signal de contrôle présente une seconde valeur.

**5.** Circuit intégré selon l'une des revendications 1 à 4, dans lequel :

- chaque cellule mémoire est reliée au premier dispositif (EPCT, PLT) par un chemin comprenant les transistors du premier sous-bloc d'un bloc de sélection de la cellule mémoire et un ou plusieurs transistors additionnels (TPI) en série avec les transistors du premier sous-bloc, et est reliée au second dispositif (RCT, SAMP) par un chemin comprenant les transistors du second sous-bloc du bloc de sélection de la cellule mémoire et un ou plusieurs transistors additionnels (TNI) en série avec les transistors du second sous-bloc,
- le ou les transistors additionnels (TPI) en série avec le premier sous-bloc est ou sont du même type de conductivité que les transistors (TP1, TP2) du premier sous-bloc, et le ou les transistors additionnels (TNI) en série avec le second sous-bloc du bloc de sélection est

ou sont du même type de conductivité que les transistors (TN1, TN2) du second sous-bloc.

6. Circuit intégré selon l'une des revendications 1 à 5, dans lequel le premier dispositif (EPCT, PLT) fournit une tension (Vp) d'effacement ou programmation de cellule mémoire et les transistors du premier type sont des transistors PMOS.

7. Circuit intégré selon l'une des revendications 1 à 6, dans lequel le second dispositif (RCT, SAMP) fournit une tension (Vr) de lecture de cellule mémoire et les transistors du second type sont des transistors NMOS.

8. Circuit intégré selon l'une des revendications 1 à 7, dans lequel le premier dispositif (EPCT, PLT) fournit une tension (Vp) égale ou proche d'une tension maximale technologique (Vmax) que peut supporter un transistor MOS basse tension, et les transistors du premier type sont des transistors PMOS.

9. Circuit intégré selon l'une des revendications 1 à 8, dans lequel le second dispositif (RCT, SAMP) fournit une tension (Vr) inférieure à la tension de seuil d'un transistor MOS, et les transistors du second type sont des transistors NMOS.

10. Circuit intégré selon l'une des revendications 1 à 9, comprenant un plan mémoire (MA) dans lequel les cellules mémoire sont reliées à des lignes de bit (BL), et dans lequel le circuit de sélection de cellule mémoire (CSEL2) est un circuit de sélection de ligne de bit comprenant pour chaque ligne de bit sélectionnable un bloc de sélection de ligne de bit (SB) comportant en parallèle un premier sous-bloc (PSB) pour relier la ligne de bit au premier dispositif (EPCT, PLT) et un second sous-bloc (NSB) pour relier la ligne de bit au second dispositif (RCT, SAMP), le premier sous-bloc ne comprenant que des transistors d'un premier type de conductivité (TP1, TP2), et le second sous-bloc ne comprenant que des transistors d'un second type de conductivité (TN1, TN2).

11. Circuit intégré selon la revendication 10, dans lequel le circuit de sélection de ligne de bit (CSEL2) est éclaté en deux parties (PCSEL, NCSEL) agencées de part et d'autre du plan mémoire (MA), la première partie ne comprenant que les premiers sous-blocs (PSB) des blocs de sélection et la seconde partie ne comprenant que les second sous-blocs (NSB) des blocs de sélection, les premiers sous-blocs (PSB) étant reliés à des premières extrémités de lignes de bit (BL) et les seconds sous-blocs (NSB) étant reliés à des secondes extrémités de lignes de bit (BL).

12. Circuit intégré selon l'une des revendications 1 à 11, dans lequel le premier et le second sous-blocs d'un bloc de sélection ne comprennent chacun qu'un seul transistor.

13. Circuit intégré selon l'une des revendications 1 à 12, dans lequel le premier et le second sous-blocs d'un bloc de sélection comprennent chacun au moins deux transistors en série (TP1, TP2, TN1, TN2).

14. Circuit intégré selon l'une des revendications 1 à 13, comprenant des points mémoire (P) à changement de phase.

15. Procédé pour appliquer à des cellules mémoire (CEL) une première tension (Vp) et une seconde tension (Vr), par l'intermédiaire d'un circuit (CSEL2) de sélection de cellule mémoire comprenant des blocs (SB) de sélection de cellule mémoire comprenant chacun des transistors de sélection de type MOS (TN1, TN2, TP1, TP2),
**caractérisé en ce qu'**il comprend des étapes consistant à :

- prévoir dans chaque bloc (SB) de sélection d'une cellule mémoire un premier sous-bloc de sélection (PSB) et un second sous-bloc de sélection (NSB) en parallèle, le premier sous-bloc (PSB) ne comprenant que des transistors MOS d'un premier type de conductivité (TP1, TP2) , et le second sous-bloc (NSB) ne comprenant que des transistors MOS d'un second type de conductivité (TN1, TN2),
- appliquer la première tension (Vp) aux cellules mémoire par l'intermédiaire des premiers sous-blocs (PSB) des blocs de sélection, et
- appliquer la seconde tension (Vr) aux cellules mémoire par l'intermédiaire des seconds sous-blocs (PSB) des blocs de sélection.

16. Procédé selon la revendication 15, comprenant une étape consistant à appliquer aux bornes de grille des transistors des premier (PSB) et second (NSB) sous-blocs des blocs de sélection, des signaux de sélection de cellule mémoire (YM, YN) polarisés de telle sorte que, quand une cellule mémoire doit être sélectionnée, le premier sous-bloc (PSB) du bloc (SB) de sélection de la cellule mémoire est dans l'état passant et le second sous-bloc (NSB) du bloc de sélection est dans l'état bloqué ou vice-versa, selon que la cellule mémoire doit être reliée au premier (EPCT, PLT) ou au second (RCT, SAMP) dispositif.

17. Procédé selon la revendication 16, comprenant une étape consistant à commander le premier sous-bloc (PSB) et le second sous-bloc (NSB) de chaque bloc de sélection au moyen des signaux de sélection identiques.

18. Procédé selon la revendication 17, comprenant des étapes consistant à :

- fournir des premiers signaux logiques de sélection (ym, yn) en fonction d'une adresse de cellule mémoire,
- fournir des seconds signaux logiques de sélection (YM, YN) présentant une valeur logique inverse de celle des premiers signaux de sélection (ym, yn) ou une valeur logique identique à celle des premiers signaux de sélection (ym, yn) selon que les cellules mémoire doivent recevoir la première tension (Vp) ou la seconde tension (Vr), et
- appliquer les seconds signaux de sélection aux premier et second sous-blocs des blocs de sélection en tant que signaux de sélection.

19. Procédé selon l'une des revendications 15 à 18, comprenant des étapes consistant à :

- appliquer la première tension (Vp) à des cellules mémoire par l'intermédiaire des transistors du premier sous-bloc d'un bloc de sélection de la cellule mémoire et d'un ou de plusieurs transistors additionnels (TPI) en série avec les transistors du premier sous-bloc et du même type de conductivité que les transistors (TP1, TP2) du premier sous-bloc, et
- appliquer la seconde tension (Vr) à des cellules mémoire par l'intermédiaire des transistors du second sous-bloc du bloc de sélection de la cellule mémoire et d'un ou de plusieurs transistors additionnels (TNI) en série avec les transistors du second sous-bloc et du même type de conductivité que les transistors (TN1, TN2) du second sous-bloc.

20. Procédé selon l'une des revendications 15 à 19, dans lequel la première tension (Vp) est une tension d'effacement ou programmation de cellule mémoire et les transistors du premier type sont des transistors PMOS.

21. Procédé selon l'une des revendications 15 à 20, dans lequel la seconde tension (Vr) est une tension de lecture de cellule mémoire et les transistors du second type sont des transistors NMOS.

22. Procédé selon l'une des revendications 15 à 21, dans lequel la première tension (Vp) est égale ou proche d'une tension maximale technologique (Vmax) que peut supporter un transistor MOS basse tension, et les transistors du premier type sont des transistors PMOS.

23. Procédé selon l'une des revendications 15 à 22, dans lequel la seconde tension (Vr) est inférieure à la tension de seuil d'un transistor MOS, et les transistors du second type sont des transistors NMOS.

24. Procédé selon l'une des revendications 15 à 23, appliqué à un plan mémoire (MA) dans lequel les cellules mémoire sont reliées à des lignes de bit (BL), et comprenant des étapes consistant à :

- agencer les premiers sous-blocs (PSB) des blocs de sélection d'un côté du plan mémoire et les relier à des premières extrémités de lignes de bit, et
- agencer les seconds sous-blocs (NSB) d'un autre côté du plan mémoire et les relier à des secondes extrémités de lignes de bit.

25. Procédé selon l'une des revendications 15 à 24, comprenant une étape consistant à ne prévoir qu'un seul transistor dans le premier et le second sous-blocs d'un bloc de sélection.

26. Procédé selon l'une des revendications 15 à 24, comprenant une étape consistant à prévoir au moins deux transistors en série (TP1, TP2, TN1, TN2) dans le premier et le second sous-blocs d'un bloc de sélection.

27. Procédé selon l'une des revendications 15 à 26, dans lequel la première tension (Vp) est une tension d'effacement ou programmation de points mémoire (P) à changement de phase et la seconde tension (Vr) est une tension de lecture de points mémoire (P) à changement de phase.

**Fig. 1**
**(Art antérieur)**

## Fig. 2
## (Art antérieur)

## Fig. 3A
## (Art antérieur)

## Fig. 3B
## (Art antérieur)

**Fig. 4**
**(Art antérieur)**

**Fig. 5**

**Fig. 6**

**Fig. 7**

**Fig. 8**

$$YM = ym*MD + (/ym*/MD)$$

$$YN = yn*MD + (/yn*/MD)$$

$$YM' = ym'*MD + (/ym'*/MD)$$

$$YN' = yn'*MD + (/yn'*/MD)$$

MD

Y

Y*MD

/Y*/MD

Y*MD + (/Y*/MD)

AM

**Fig. 9**

RCT (SAMP)

NCSEL (NSB)

• • •

MA

CDEC2

PCSEL (PSB)

• • •

EPCT (PLT)

CSEL2

**Fig. 10**

**Fig. 11**

**Office européen des brevets**

## RAPPORT DE RECHERCHE EUROPEENNE

Numéro de la demande

EP 07 01 5336

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2004/027907 A1 (OOISHI TSUKASA [JP]) 12 février 2004 (2004-02-12)<br><br>* figure 16 *<br>----- | 1,2,7,9, 12, 14-16, 21,23,25 | INV. G11C16/02 G11C7/10 |
| X | US 2004/179398 A1 (KLEVELAND BENDIK [US] ET AL) 16 septembre 2004 (2004-09-16)<br><br><br>* alinéas [0048], [0050], [0103]; figures 4,8 *<br>----- | 1-3, 5-10, 13-17, 19-23, 26,27 | |
| X | US 2005/128799 A1 (KUROTSUCHI KENZO [JP] ET AL KUROTSUCHI KENZO [JP] ET AL) 16 juin 2005 (2005-06-16) * page 1 *<br>----- | 1,6-9, 14,15, 20-23,27 | |
| X | US 2006/158929 A1 (HIDAKA HIDETO [JP]) 20 juillet 2006 (2006-07-20)<br><br>* figure 30 *<br>----- | 1,6,8, 15,20, 22,24 | DOMAINES TECHNIQUES RECHERCHES (IPC) G11C |
| A | US 2005/185445 A1 (OSADA KENICHI [JP] ET AL) 25 août 2005 (2005-08-25) * le document en entier *<br>----- | 1-27 | |

Le présent rapport a été établi pour toutes les revendications

| Lieu de la recherche | Date d'achèvement de la recherche | Examinateur |
|---|---|---|
| Munich | 21 novembre 2007 | Havard, Corinne |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

        ...............................................................

& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 07 01 5336

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-11-2007

| Document brevet cité au rapport de recherche | | | Date de publication | Membre(s) de la famille de brevet(s) | | Date de publication |
|---|---|---|---|---|---|---|
| US | 2004027907 | A1 | 12-02-2004 | CN | 1477639 A | 25-02-2004 |
| | | | | JP | 2004079033 A | 11-03-2004 |
| | | | | TW | 584852 B | 21-04-2004 |
| US | 2004179398 | A1 | 16-09-2004 | AUCUN | | |
| US | 2005128799 | A1 | 16-06-2005 | CN | 1624803 A | 08-06-2005 |
| | | | | JP | 2005166210 A | 23-06-2005 |
| | | | | KR | 20050054851 A | 10-06-2005 |
| | | | | US | 2006274593 A1 | 07-12-2006 |
| US | 2006158929 | A1 | 20-07-2006 | AUCUN | | |
| US | 2005185445 | A1 | 25-08-2005 | CN | 1658328 A | 24-08-2005 |
| | | | | JP | 2005267837 A | 29-09-2005 |
| | | | | KR | 20060042055 A | 12-05-2006 |
| | | | | US | 2007159871 A1 | 12-07-2007 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1450373 A

- FR 2006001686 W